# DEMANDE DE BREVET EUROPEEN

(11) **EP 2 413 132 A1**
(43) Date de publication de la demande: **01.02.2012**
(21) Numéro de dépôt: 11175020.4
(22) Date de dépôt: 22.07.2011
(51) Int. Cl.: G01N 21/88, G01N 21/956, G01B 11/25, G06T 3/40

(54) **Installation d'inspection optique de circuits électroniques**

(30) Priorité: 26.07.2010 FR 1056085
(71) Demandeur: VIT, 38120 Saint-Egreve (FR)
(72) Inventeur: Perriollat, Mathieu, 38600 FONTAINE (FR)
(74) Mandataire: de Beaumont, Michel

(57) **Abrégé**

L'invention concerne une installation d'inspection optique de circuits intégrés ou analogues, comportant : un convoyeur plan selon une première direction (X) des objets à analyser et un système de prise de vues placé à l'aplomb d'une zone du convoyeur et dans une position fixe par rapport à celui-ci, le système de prise de vues comportant au moins un premier ensemble de caméras numériques (22) comportant chacune un réseau matriciel orthogonal de pixels, lesdites caméras étant alignées dans une deuxième direction (Y) différente de la première, les caméras étant toutes orientées de sorte qu'une des directions orthogonales de leur réseau de pixels fasse un premier angle (α) avec la première direction

## Description

### Domaine de l'invention

La présente invention concerne de façon générale les systèmes d'inspection optique et, plus particulièrement, les systèmes destinés à l'analyse en ligne de circuits électroniques. L'invention concerne plus particulièrement les systèmes équipés de caméras numériques.

### Exposé de l'art antérieur

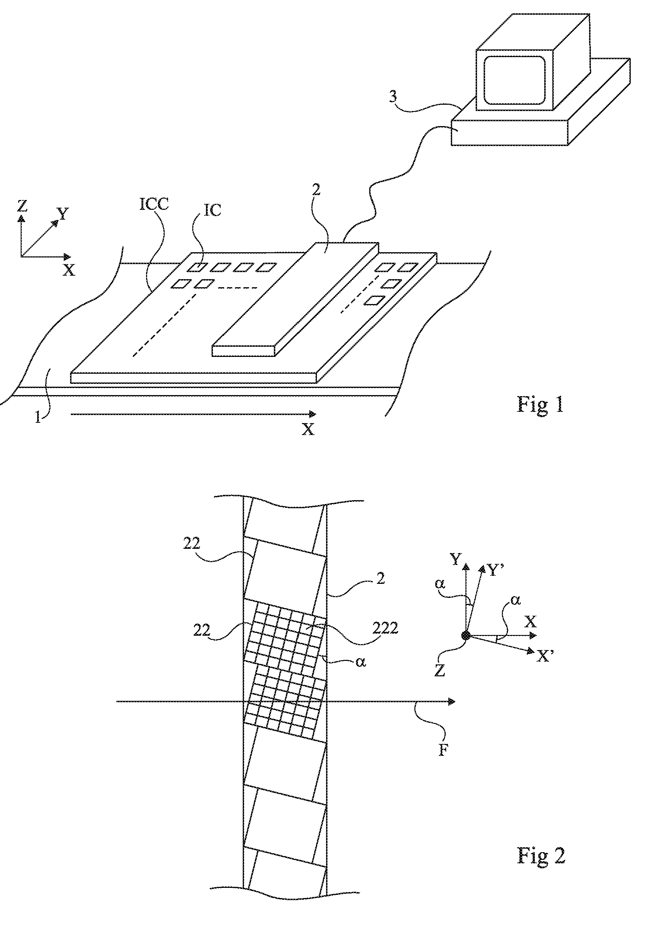

La figure 1 représente, de façon très schématique, une installation du type à laquelle s'applique à titre d'exemple la présente invention. Des circuits électroniques IC, par exemple portés par une carte de circuit imprimé ICC, sont placés, par exemple, sur un convoyeur d'une installation en ligne d'inspection optique. Cette installation comporte un système 2 de caméras numériques, relié à un système informatique 3 de traitement d'images. Le convoyeur 1 est susceptible de se déplacer dans un plan X, Y (généralement horizontal) et, pour une série de prises de vues, uniquement selon une des deux directions, la direction X.

Pour réduire les coûts de traitement, on cherche généralement à compenser une qualité (résolution) limitée des images par un traitement numérique de ces images. En particulier, on a déjà proposé de compenser une faible résolution d'une caméra par une prise de plusieurs images légèrement décalées les unes par rapport aux autres dans les deux directions du plan et par la mise en oeuvre d'un procédé dit de super-résolution.

Par exemple, le document W02009/090633 décrit une installation d'inspection utilisant un réseau matriciel de plusieurs caméras numériques qui est déplacé par rapport à l'objet photographié pour mettre en oeuvre un procédé de super-résolution. Pour accroître la résolution des images dans les deux directions du plan au moyen d'un tel système, il est nécessaire d'utiliser un réseau de caméras et de le déplacer soit dans les deux directions du plan soit dans une direction oblique par rapport à la direction de convoyage. Cela complique la mécanique du système et accroît son coût en raison de la précision requise pour les moteurs de déplacement.

Un autre objectif de certains systèmes d'inspection optique est d'obtenir des images en trois dimensions. Une installation telle que décrite dans le document mentionné ci-dessus n'est pas adaptée à la reconstitution d'images en trois dimensions.

Il serait souhaitable de disposer d'une installation d'analyse d'objets de type circuits intégrés par traitement d'image qui autorise l'utilisation d'un nombre moindre de caméras que les systèmes classiques, sans perte de résolution.

Il serait également souhaitable de disposer d'une installation adaptée à l'analyse en trois dimensions.

Il serait également souhaitable de disposer d'un système peu onéreux par rapport aux solutions connues.

### Résumé

Un objet d'un mode de réalisation de la présente invention est de proposer une installation d'inspection par analyse d'images qui pallie tout ou partie des procédés et installations connus.

Selon un premier aspect, un objet d'un mode de réalisation de la présente invention est de proposer une solution particulièrement adaptée à un traitement en ligne et simplifiant les déplacements.

Selon ce premier aspect, un autre objet d'un autre mode de réalisation de la présente invention est de proposer une solution particulièrement simple pour une analyse en deux dimensions.

Selon un second aspect, un objet d'un mode de réalisation de la présente invention est de proposer une solution adaptée à l'obtention d'images en trois dimensions.

Un autre objet d'un mode de réalisation est de proposer une solution compatible avec les deux aspects.

Pour atteindre tout ou partie de ces objets ainsi que d'autres, il est prévu une installation d'inspection optique de circuits intégrés ou analogues, comportant :
un convoyeur plan selon une première direction des objets à analyser ;
un système de prise de vues placé à l'aplomb d'une zone du convoyeur et dans une position fixe par rapport à celui-ci, le système de prise de vues comportant au moins un premier ensemble de caméras numériques comportant chacune un réseau matriciel orthogonal de pixels, lesdites caméras étant alignées dans une deuxième direction différente de la première, les caméras étant toutes orientées de sorte qu'une des directions orthogonales de leur réseau de pixels fasse un premier angle avec la première direction.

Selon un mode de réalisation de la présente invention, la deuxième direction est perpendiculaire à la première.

Selon un mode de réalisation de la présente invention, les pixels des différentes caméras sont alignés avec la deuxième direction.

Selon un mode de réalisation de la présente invention, un système de traitement d'images est adapté à appliquer un traitement de super-résolution à une succession d'images fournies par le système de prise de vues.

Selon un mode de réalisation de la présente invention, le premier angle est compris entre 3 et 20 degrés.

Selon un mode de réalisation de la présente invention, l'installation comporte un deuxième ensemble de caméras, parallèle au premier dans la deuxième direction, toutes les caméras ayant leurs axes optiques respectifs inclinés d'un second angle par rapport à une troisième direction perpendiculaire aux deux autres.

Selon un mode de réalisation de la présente invention, l'installation comporte en outre deux projecteurs de motifs déterminés, ces motifs étant tels que deux droites projetées par chacun des projecteurs sont alignées dans un plan défini par les deux premières directions et sont coplanaires à une droite reliant les centres optiques des deux projecteurs.

Selon un mode de réalisation de la présente invention, le second angle est compris entre 15 et 25 degrés.

On prévoit également un procédé de commande d'une telle installation d'inspection optique.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 décrite précédemment représente de façon très schématique un exemple d'installation d'inspection de circuits intégrés du type auquel s'applique la présente invention ;
la figure 2 est une représentation schématique de capteurs numériques selon un mode de réalisation du premier aspect de la présente invention ;
la figure 2A est une représentation schématique de capteurs numériques selon un autre mode de réalisation du premier aspect de la présente invention ;
la figure 3 illustre le fonctionnement du système de la figure 2 ;
la figure 4 est une perspective schématique d'un mode de réalisation selon le second aspect de la présente invention ;
les figures 5 et 5A illustrent le fonctionnement d'une réalisation à deux projecteurs telle qu'illustrée en figure 4 ;
la figure 6 est une perspective schématique d'un autre mode de réalisation d'une installation selon le second aspect de la présente invention ; et
la figure 7 est une représentation schématique illustrant les angles pris en compte dans l'installation de la figure 6.

### Description détaillée

De mêmes éléments ont été désignés par de mêmes références aux différentes figures qui ont été tracées sans respect d'échelle. Par souci de clarté, seuls les étapes et éléments utiles à la compréhension de l'invention ont été représentés et seront décrits. En particulier, les algorithmes de traitement d'image utilisés par l'invention sont en eux-mêmes connus et ne seront pas détaillés. De plus, la réalisation pratique d'un capteur d'images numériques n'a pas été détaillée, l'invention étant compatible avec toute caméra matricielle noir et blanc ou couleur usuelle, par exemple les capteurs à transfert de charges (CCD - Charge-Coupled Device) ou les capteurs CMOS.

L'invention sera d'abord décrite en relation avec son premier aspect, appliqué à un exemple de mise en oeuvre pour une installation de prise de vue en deux dimensions.

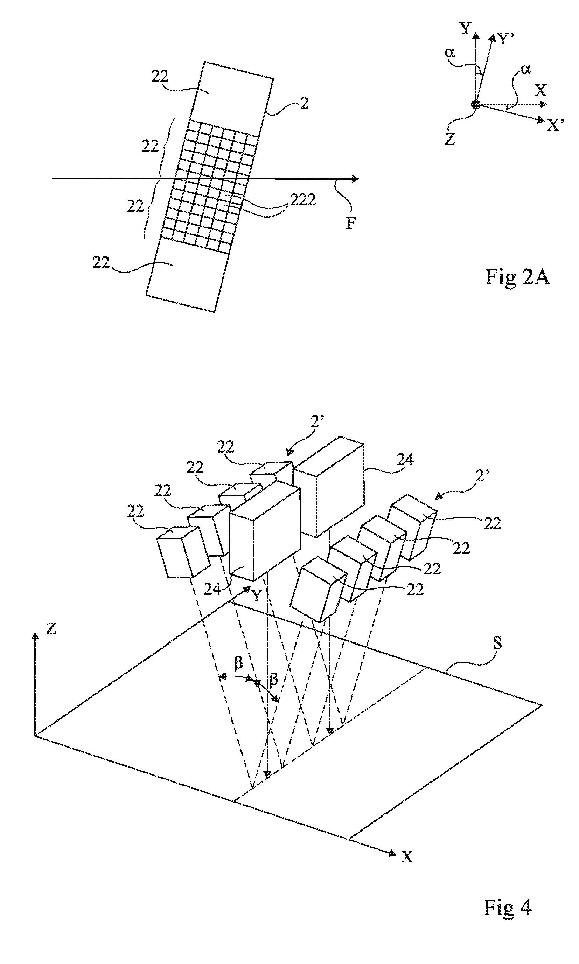

La figure 2 est une vue schématique de dessus représentant un ensemble 2 de capteurs d'image 22 d'une installation d'analyse selon un mode de réalisation du premier aspect de l'invention. On prévoit de déplacer les objets à photographier (par exemple, les circuits intégrés de la figure 1) par rapport au système de capteurs et que ces derniers soient fixes. Pour une installation de prise de vue bidimensionnelle, les capteurs 22 sont tous coplanaires dans un plan parallèle au plan (X, Y) du convoyeur des circuits.

Dans le mode de réalisation de la figure 2, les capteurs d'image sont placés de telle sorte que leurs pixels respectifs 222 forment un réseau selon des directions perpendiculaires entre-elles mais non alignées avec les axes X et Y. Cela revient à faire pivoter chaque capteur d'un même angle α autour de l'axe vertical Z, de sorte que les pixels sont selon des directions parallèles à des axes X', Y' définissant un repère faisant un angle α par rapport au repère X, Y. Les capteurs 22 sont néanmoins ici alignés selon la direction Y, c'est-à-dire perpendiculairement à la direction X de convoyage. Lors d'un déplacement d'un objet sous le système de caméras 2 selon la direction F parallèle à l'axe X, un point de l'objet passe d'un pixel à un autre dans les deux directions des capteurs c'est-à-dire à des positions différentes dans le pixel.

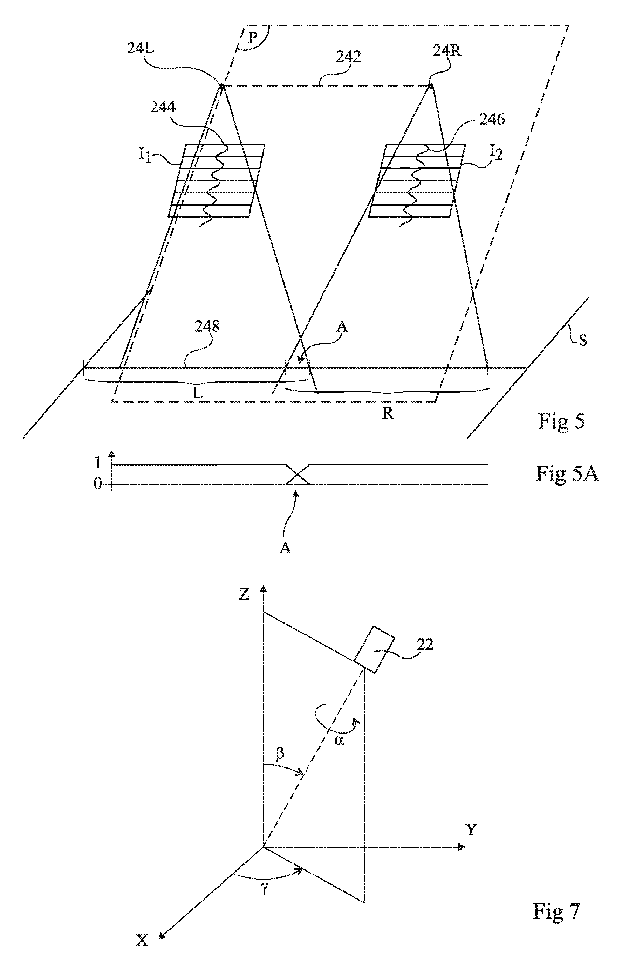

La figure 2A illustre une variante selon laquelle les capteurs 22 sont alignés avec l'axe Y'. La rangée de capteurs est alors inclinée par rapport à l'axe Y d'un angle α. Par rapport au mode de réalisation de la figure 5, un avantage est qu'un réglage de l'angle α est plus simple car il s'effectue en une seule fois sur tous les capteurs.

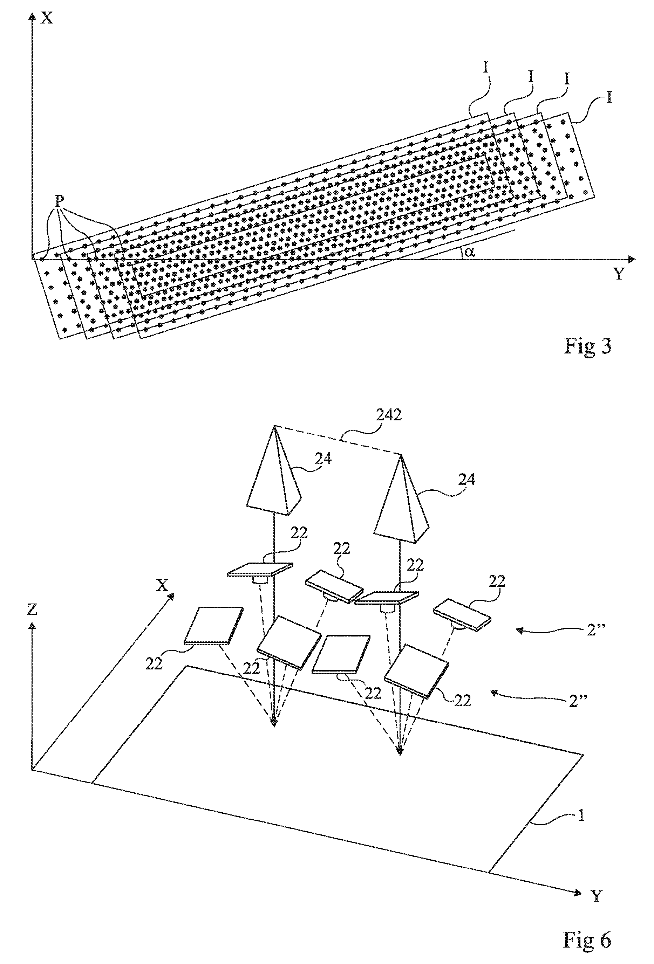

La figure 3 est une vue schématique de dessus illustrant quatre images successives I prises par le réseau de capteurs et les positions respectives de points objets dans ces images. Le déplacement du point objet dans la direction X entraîne qu'une fois les images superposées, un point objet est dupliqué quatre fois en étant décalé en position X et Y. On notera que cette duplication ne requiert pas d'augmenter le nombre de caméras dans la direction X.

Une augmentation de la résolution de l'image est obtenue en superposant les images successives prises par le capteur suite au déplacement de l'objet. Le traitement des images par un processus dit de super-résolution est en lui-même usuel. La position des images les unes par rapport aux autres est, selon l'invention, fixe dans la direction (Y) perpendiculaire au déplacement. De plus, dans l'autre direction (X), cette position est liée à l'angle α (fixe et commun à tous les capteurs) et au pas de translation entre deux images. Dans un déplacement pas à pas ou continu, ce pas de translation dépend du nombre d'images choisi pour la super-résolution. La vitesse de progression du convoyeur et la fréquence des prises d'image sont choisies pour respecter ce pas de translation.

La densité des pixels dans une image de super-résolution dépend, entre autres, du nombre d'images et de l'angle α de rotation des caméras.

De plus, l'angle α conditionne l'homogénéité de l'échantillonnage des objets dans les images. Cette homogénéité peut être déterminée à partir de méthodes usuelles en traitement d'images. On pourra par exemple se référer à la publication "Constrained CVT meshes and a comparison of triangular mesh generators" de Hoa Nguyen, John Burkardt, Max Gunzburger, Lili Ju, Yuki Saka, publiée en 2008 dans Computational Geometry: Theory and Applications, Elsevier B.V. (http://www.sciencedirect.com/science? ob=ArticleURL& udi=B6TYS-4SCKRTM-1& user=10& coverDate=01%2F2009& rdoc=1& fmt=hight& orig=sea rch& sort=d& docanchor=&view=c& searchStrId=1379367209& rerunOri gin=google& acct=C000050221& version=1& urlVersion=0& userid=10& md5-b799274058738c6fb4d1b52dfdd44ee7), qui décrit différentes méthodes de détermination d'homogénéité d'image, par exemple la mesure "the regularity mesure" (page 8).

L'inventeur a constaté qu'un angle α compris entre 3 et 20 degrés fournissait des résultats acceptables dans l'application visée.

Un avantage de la solution proposée est qu'en modifiant l'angle α, on change le paramètre de translation (le pas entre deux images) donc la résolution dans les deux directions. En variante, on détermine à l'avance un même angle α satisfaisant pour plusieurs nombres d'images. La résolution peut alors être changée simplement en modifiant le pas (donc le nombre d'images).

A titre d'exemple particulier de réalisation, on peut obtenir une résolution pour un point objet représentant approximativement une dizaine de micromètres de diamètre (par exemple 13 micromètres) au moyen d'un capteur de 3 mégapixels ayant une résolution nominale de 52 micromètres. Avec six images, on obtient une résolution équivalente à un capteur de 18 mégapixels ayant une résolution acceptable pour un objet de 21 micromètres.

On aurait pu penser pivoter les objets à examiner sur le convoyeur et garder des caméras optiques dont les pixels sont tous alignés dans une direction perpendiculaire à la direction du convoyage comme dans la solution usuelle. Toutefois, une telle solution ne permettrait pas un traitement de super-résolution fonctionnel avec une seule ligne de caméras.

Un avantage des modes de réalisation décrits ci-dessus de l'invention selon son premier aspect est qu'ils permettent de réduire le nombre de caméras dans un fonctionnement en super-résolution, donc une économie de coût. De plus, on économise la motorisation du système de prise de vues et on améliore la profondeur de champ.

Un second aspect de la présente invention sera décrit par la suite. Selon cet aspect, on vise l'acquisition d'images en trois dimensions.

Pour une application à des images en trois dimensions, il est usuel d'utiliser plusieurs caméras pour prendre un nuage de points et, pour mettre en correspondance les images des différentes caméras, de projeter sur la scène un motif déterminé. Un exemple de processus de traitement d'images en trois dimensions est décrit dans le brevet américain 6 545 512.

On utilise préférentiellement une technique connue sous la dénomination "décalage de phase" (phase-shift) qui consiste à projeter des motifs sinusoïdaux sur la scène à examiner. L'interprétation de ces motifs dans les images sert à déduire les altitudes des différents points objets de la scène.

Pour l'obtention d'une image tridimensionnelle, plusieurs caméras doivent observer la même portion de la scène. Un problème est alors que la lumière projetée par un unique projecteur de recalage risque de créer des zones d'ombre liées à la présence même des caméras dans le champ du projecteur.

Pour résoudre ce problème, on pourrait penser utiliser deux projecteurs pour éclairer la scène selon des angles différents. Toutefois, se pose alors le problème des zones de recouvrement où les franges projetées font un angle entre elles. Une solution envisageable serait d'allumer successivement les différents projecteurs. Toutefois, cela engendrerait une perte en temps de traitement des images (temps multiplié par le nombre d'allumages successifs). Un autre problème est qu'il faudrait alors des projecteurs de résolution élevée donc coûteux et non disponibles aujourd'hui.

Selon cet aspect de la présente invention, on choisit un motif particulier d'images projetées permettant de résoudre aisément les zones de recouvrement entre les projecteurs.

La figure 4 est une perspective schématique des positions respectives de caméras et de projecteurs selon un mode de réalisation de la présente invention. Dans cet exemple, on prévoit deux projecteurs 24 d'images dans la scène et deux groupes 2' de quatre caméras 22 alignées selon deux droites parallèles dans la direction Y. Les deux groupes 2' sont placés de part et d'autres des projecteurs 24, également alignés selon une droite parallèle à la direction Y. Les caméras sont positionnées de sorte que leurs points de visée respectifs sont alignés selon la direction Y et sont appariés, une caméra de chaque groupe visant le même point que la caméra de l'autre groupe avec laquelle elle est symétrique par rapport à l'axe Y. Cela revient à incliner toutes les caméras d'un angle β par rapport à la verticale Z. L'angle β peut être identique (au signe près) pour toutes les caméras 22.

Deux projecteurs 24 sont disposés pour projeter dans la scène (dans la zone de prise de vues) un motif déterminé qui sera décrit ci-dessous et qui est reconnu par le système de traitement. Connaissant le(s) motifs, les paramètres des projecteurs et les paramètres des caméras, on peut alors obtenir l'information d'altitude dans la scène.

La hauteur de l'objet inspecté sur le convoyeur n'est pas précise. Lorsque l'objet est plus bas que la hauteur de référence, la zone située entre les projecteurs est illuminée par les deux projecteurs. En revanche, si l'objet est plus haut que la hauteur de référence, une partie de l'objet peut ne plus être éclairée, il est alors nécessaire d'introduire une zone de recouvrement préventive pour pallier à ce problème. Dans tous les cas, la zone de recouvrement doit être traitée.

Soit on introduit un codage dans les images projetées pour identifier la source (par exemple en longueur d'onde), soit le motif projeté dans les zones de recouvrement est tel que les traitements d'image associés à cette zone sont indépendants du projecteur. L'invention s'applique à la deuxième solution. La contrainte à appliquer sur les motifs est que les niveaux de gris doivent être constants le long des courbes définies par l'intersection entre les plans images des projecteurs et les plans contenant une droite reliant les centres optiques des deux projecteurs.

Les figures 5 et 5A illustrent un tel mode de réalisation. La figure 5 représente schématiquement une installation à deux projecteurs. La figure 5A illustre schématiquement l'intensité (luminance) de l'image à projeter en fonction de la position par rapport à la zone de recouvrement. L'explication qui suit n'est pas corrélée au système de caméras pour des raisons de clarté.

Deux images I1 et I2 sont projetées par deux projecteurs 24L et 24R sur la scène S correspondant à la zone de prise de vues. Par exemple, il s'agit de lignes parallèles (fentes). Comme il ressort de la figure 5, l'intersection entre les images projetées I1 et I2 et tout plan P incluant la ligne 242 fournit des courbes parallèles 244 et 246. De plus, la projection de ces courbes 244 et 246 sur la scène fournit deux droites 248 L et R alignées. Comme l'illustre la figure 5A, pour respecter le bilan photométrique du système dans la zone de recouvrement A, le profil d'image à projeter est adapté dans cette zone. Par exemple, un niveau normalisé de luminance provenant de chaque image est adapté (décroissant d'un côté, croissant de l'autre) pour que la superposition des deux images donne un niveau constant sur la scène.

Le mode de réalisation ci-dessus est compatible avec un traitement d'image en super-résolution.

On pourra par exemple appliquer un traitement de super-résolution usuel consistant à faire bouger la scène (ou l'ensemble de prise de vues) dans les deux directions X et Y du plan.

Selon un exemple préféré, on combine les deux aspects décrits pour appliquer le processus de super-résolution au système de prise de vues 3D.

La figure 6 est une vue en perspective du système de prise de vues d'un autre mode de réalisation adapté à l'obtention d'images en trois dimensions (3D) en super-résolution. Pour simplifier, les liaisons au système de traitement n'ont pas été représentées.

La figure 7 est une représentation géométrique illustrant les angles intervenant dans l'installation de la figure 6.

Par rapport au mode de réalisation de la figure 4, les caméras 22 sont orientées pour viser, par groupe de quatre, un même point. Cela revient à ajouter un degré de liberté illustré par la figure 7. En plus de l'inclinaison d'angle β de préférence identique en valeur absolue pour toutes les caméras, les caméras sont pivotées d'un angle γ pour diriger leurs axes de visée respectifs, par groupe de quatre, sur un même point.

De plus, pour respecter les caractéristiques du premier aspect, les caméras sont toutes pivotées autour de l'axe Z d'un angle α.

Par rapport au mode de réalisation de la figure 2, deux séries 2" de caméras 22 sont disposées selon deux droites parallèles à la direction Y. Dans l'exemple des figures 4 et 6, chaque série 2', 2" comporte quatre caméras 22 alignées dans la direction Y mais ce nombre pourra être différent en fonction de la largeur de la scène à photographier dans la direction Y perpendiculaire au déplacement des objets.

Les angles β et γ et le point de visée sont choisis en fonction de la précision en Z souhaitée dans la scène en tenant compte de la profondeur de champ.

A titre d'exemple particulier de réalisation, on peut prévoir un système dans lequel l'angle α est compris entre 3 et 6 degrés, l'angle β étant compris entre 15 et 25 degrés.

Divers modes de réalisation ont été décrits. Diverses variantes et modifications apparaîtront à l'homme de l'art. En particulier, le choix des placements des caméras et des angles dépend de la résolution souhaitée et de la taille des points d'objet à analyser. D'autres configurations que celles décrites pour exemple en relation avec les figures 4 et 6 pourront être prévues, que ce soit en nombre ou en positions des caméras et projecteurs.

De plus, le choix du nombre de pixels par caméra conditionne la résolution obtenue pour une vitesse de convoyage donnée. En outre, on pourra utiliser des capteurs matriciels plutôt que carrés.

Enfin, les traitements à appliquer aux images prises sont à la portée de l'homme du métier à partir des indications fonctionnelles données ci-dessus et en utilisant des algorithmes usuels de traitement d'images.

## Revendications

1. Installation d'inspection optique de circuits intégrés ou analogues, comportant :
un convoyeur plan (1) selon une première direction (X) des objets à analyser ;
un système de prise de vues (2) placé à l'aplomb d'une zone du convoyeur et dans une position fixe par rapport à celui-ci, le système de prise de vues comportant au moins un premier ensemble (2) de caméras numériques (22) comportant chacune un réseau matriciel orthogonal de pixels, lesdites caméras étant alignées dans une deuxième direction (Y, Y') différente de la première, les caméras étant toutes orientées de sorte qu'une des directions orthogonales de leur réseau de pixels fasse un premier angle (α) avec la première direction.

2. Installation selon la revendication 1, dans laquelle la deuxième direction est perpendiculaire à la première.

3. Installation selon la revendication 1, dans laquelle les pixels des différentes caméras sont alignés avec la deuxième direction.

4. Installation selon l'une quelconque des revendications 1 à 3, dans laquelle un système de traitement d'images est adapté à appliquer un traitement de super-résolution à une succession d'images fournies par le système de prise de vues.

5. Installation selon l'une quelconque des revendications 1 à 4, dans laquelle le premier angle (α) est compris entre 3 et 20 degrés.

6. Installation selon l'une quelconque des revendications 1 à 5, comportant un deuxième ensemble de caméras (22), parallèle au premier dans la deuxième direction (Y), toutes les caméras ayant leurs axes optiques respectifs inclinés d'un second angle (β) par rapport à une troisième direction (Z) perpendiculaire aux deux autres.

7. Installation selon la revendication 6, comportant en outre deux projecteurs (24) de motifs déterminés, ces motifs étant tels que deux droites projetées par chacun des projecteurs sont alignées dans un plan défini par les deux premières directions (X, Y) et sont coplanaires à une droite (242) reliant les centres optiques des deux projecteurs.

8. Installation selon l'une quelconque des revendications 6 et 7, dans laquelle le second angle (β) est compris entre 15 et 25 degrés.
